# EUROPÄISCHE PATENTANMELDUNG

(11) **EP 1 280 196 A1**
(43) Veröffentlichungstag der Anmeldung: **29.01.2003**
(21) Anmeldenummer: 01810711.0
(22) Anmeldetag: 18.07.2001
(51) Int. Cl.: H01L 21/60, H01L 21/603, H01L 21/00

(54) **Verfahren zum Befestigen von elektronischen Bauelementen auf Substraten**

(71) Anmelder: ABB RESEARCH LTD., 8050 Zürich (CH)
(72) Erfinder: Knapp, Wolfgang, 5430 Wettingen (CH)
(74) Vertreter: ABB Patent Attorneys

(57) **Zusammenfassung**

Beim Verfahren zum Befestigen von elektronischen Bauelementen auf Substraten durch Drucksintern wird eine aus einem Metallpulver und einem Lösungsmittel bestehende Paste zwischen dem Bauelement und dem Substrat aufgetragen. Nachdem die Paste vollständig getrocknet ist, wird das Bauelement auf das Substrats aufgesetzt. Mehrere solche Anordnungen (4) mit Substrat und Bauelement werden anschliessend bei Sintertemperatur in einer Isostatischen Presse (6) zusammengepresst.

Eine grosse Anzahl komplexer und/ oder fragiler Teile können gleichzeitig und mit höchster Präzision Verbunden werden.

## Beschreibung

### Technisches Gebiet

Die vorliegende Erfindung bezieht sich auf das Gebiet der Leistungselektronik. Sie betrifft ein Verfahren zum Befestigen von elektronischen Bauelementen auf Substraten durch Drucksintern, gemäss dem Oberbegriff des Patentanspruchs 1.

### Stand der Technik

Ein solches Drucksinterverfahren ist aus der EP 0 330 895 B1 bekannt. Dabei wird eine aus einem Substrat und einem leistungselektronischen Bauelement bestehende Anordnung in eine Presse mit zwei Pressenstempel eingebracht. Zwischen der Oberseite des Baueelements und dem einen Pressenstempel ist ein elastisch verformbarer Körper aus temperaturbeständigem Material angeordnet. Durch den deformierbaren Körper wird der Druck beim Pressen gleichmässiger auf die miteinander zu verbindenden Teile übertragen.

Allerdings ist der deformierbare Körper bei komplizierteren Formen der zu verbindenden Teile in der Regel nicht flexibel genug, um den Druck wirklich flächendeckend gleichmässigen zu übertragen. Thermische Ausdehnung des deformierbaren Körpers können zudem zu Verschiebungen der zu verbindenden Teile und/ oder zu Brüchen der mitunter sehr zerbrechlichen Bauelementen führen.

### Kurze Darstellung der Erfindung

Die Aufgabe der vorliegenden Erfindung besteht demzufolge darin, ein Verfahren der eingangs genannte Art zu schaffen, mit dem auch Bauelemente mit strukturierter oder zerklüfteter Oberseite auf einem Substrat befestigt werden können, ohne dass mechanische Beschädigungen des Bauelements hervorgerufen werden.

Die Aufgabe wird erfindungsgemäss durch die Merkmale des unabhängigen Anspruchs 1 gelöst.

Im erfindungsgemässen Verfahren wird die Anordnung mit Bauelement und Substrat zum Zusammenpressen in eine Druckkammer einer isostatischen Presse eingebracht darin durch ein unter erhöhtem Druck stehendes Fluid zusammengepresst wird.

Durch das Fluid wird ein absolut gleichmässiger Druck auf die zusammenzupressende Anordnung ausgeübt, ohne dass dabei mechanische Spannungen verursachen werden, die zu Schäden an dem Bauelement führen könnten.

In einer bevorzugten Ausführungsform des erfindungsgemässen Verfahrens wird die Anordnung vor dem Pressen in eine elastisch verformbare, gasdichte Hülle eingebracht und diese anschliessend verschlossen.

Die gasdichte Hülle sorgt dafür, dass das Fluid nicht zwischen die zu verbindenden Teile gelangt, und/ oder dass die zu verbindenden Teile selbst nicht durch das Fluid beschädigt werden. Die Hülle dient zudem als Schutz der Anordnung während der Lagerung und dem Transport.

Besonders vorteilhaft ist, wenn die Hülle mit der Anordnung vor dem Zusammenpressen evakuiert wird. Dadurch werden die zu verbindenden Teile relativ zueinander fixiert, was wiederum Lagerung und Transport vereinfacht.

In einer Druckkammer können auch mehere solcher Anordnungen mit Bauelement und Substrat gleichzeitig zusammengepresst werden. Dadurch erhöht sich der Durchsatz bei absolut gleichbleibender Qualität der erzeugten Verbindungen.

### Kurze Beschreibung der Zeichnungen

Die Erfindung wird nachfolgend anhand der Zeichnungen näher erläutert. Dabei zeigt:
- Fig. 1: eine zur Durchführung des erfindungsgemässen Verfahrens geeignete Anordnung mit elektrischem Bauelement und Substrag im Querschnitt,
- Fig. 2 a) und b): wesentliche Schritte einer bevorzugten Ausführungsform des erfindungsgemässen Verfahrens mit einer Anordnung nach Fig. 1 und
- Fig. 3: die Anordnung nach Fig. 1 während der Druckübertragung.

### Weg zur Ausführung der Erfindung

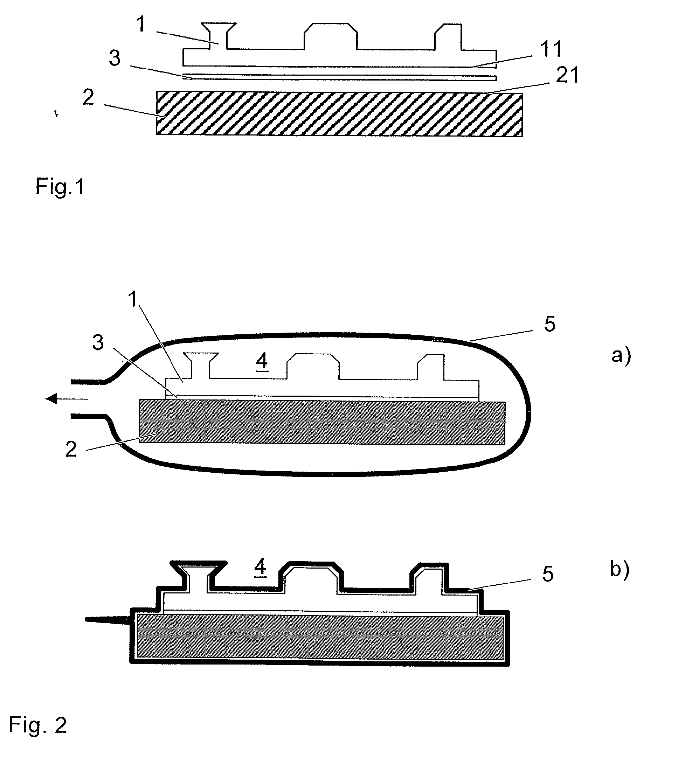

Die wesentlichen Verfahrensschritte des erfindungsgemässen Verfahrens werden anhand der Fig. 1 und Fig. 2 a) und b) erläutern. Die Darstellungen sind skizzenhaft und bezüglich der Längenverhältnissen nicht massstabsgetreu.

Fig. 1 zeigt ein elektrisches Beuelement 1 welches auf einem Trägersubstrat 2 befestigt werden soll.

Beim Bauelement 1 handelt es sich beispielsweise um ein Halbleiterbauelement (Thyristor, GTO, IGBT) mit mehreren, obenliegenden Kontakt- und/oder Steuerelektroden. Die verschiedenen Elektroden führen zu einer mehr oder weniger stark konturierten Oberfläche. Die Unterseite 11 des Bauelements ist mit einer Kontaktierungsschicht überzogen.

Beim Substrat handelt es sich beispielweise um eine 1.5 mm starke Scheibe aus Molybdän mit einem Durchmesser von ca. 30 mm. Diese ist wenigstens auf der dem Bauelement 1 zugewandten Seite mit einer Kontaktschicht 21 versehen, welche etwa 2 bis 3 µm dick ist und beispielsweise aus Silber besteht.

Zum Befestigen des Bauelements wird auf der Kontaktschicht 11 des Bauelements und/oder auf der Kontaktschicht 21 des Substrats eine Sinterschicht 3 aus Metallpulver, insbesondere Silberpulver, aufgetragen. Die Sinterschicht 3 kann beispielsweise in der Form einer Paste aufgetragen werden, welche im Wesentlichen aus dem Silberpulver und einem Lösungsmittel besteht. Diese Paste wird nach dem Auftragen durch Austreiben des Lösungsmittels getrocknet. Die Trockenzeit beträgt bei Raumteperatur ca. 30 Minuten. Bei erhöhter Temperatur reduziert sich die Trockenzeit auf wenige Minuten.

Anschliessend wird das Bauelement 1 auf das Substrat 2 aufgesetzt.

Wie Fig. 2 a) zeigt, wird die aus den aufeinandergesetzten Teilen gebildete Anordnung 4 in eine gasdichte, elastische Kunststoffhülle 5 eingebracht, welche anschliessend mindestens teilweise evakuiert und verschlossen wird. Die elastische Hülle schmiegt sich den Konturen der Anordnung an, wie dies in Fig. 2 b) dargestellt ist. Durch das Evakuieren der Hülle wird die Anordnung zusätzlich stabilisiert. Vor und während dem Pressen können sich dadurch Bauteil und Substrat nicht verschieben.

Die Hülle ist aus einem Material mit hoher thermischen Leitfähigkeit gefertigt, beispielsweise Si-Gummi oder verdichtete PTFE-Folie, welche sich in Versuchen als besonders geeignet erwies.

Alternativ zum Einbringen der Anordnung in die Hülle, kann auch nur der Kontaktbereich zwischen dem Bauelement und dem Substrat mit einer schützenden Schicht aus beispielsweise Gummipaste abgedichtet werden.

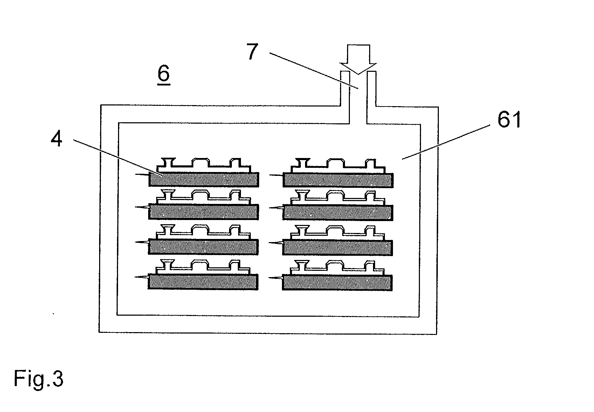

Wie Fig. 3 zeigt, werden anschliessend mehrere solcher Anordnungen 4 in die Druckkammer 61 einer isostatischen Presse 6 eingebracht. Eine solche isostatische Presse ist beispielsweise aus der US 6,250,907 bekannt.

Der Anpressdruck in der Druckkammer wird durch ein Fluid (Flüssigkeit oder Gas) 7 erzeugt, welches unter erhöhtem Druck in die Druckkammer 61 gepresst wird. Vor, während und/ oder nach dem Einbringen in die Druckkammer wird das Fluid auf Sintertemperatur zwischen 150 und 250°C aufgeheizt.

Eine gute Verbindung wird dadurch erreicht, dass auf die Anordnung während einer Sinterzeit von einigen wenigen bis zu 60 Sekunden ein Druck von ca. 4'000 N/cm² ausgeübt wird.

Durch erhöhen des Drucks und/ oder der Sintertemperatur wird die Sinterzeit reduziert.

Aus Sicherheitsgründen werden vorteilhafterweise Druckfluide verwendet, deren Siedetemperatur bei gegebenem Druck oberhalb der Sintertemperatur liegten (beispielsweise GALDEN HT, Siedetemperatur von 309°C).

Nach dem Sintern wird die Anordnung wieder der elastischen Hülle entnommen.

### Bezugszeichenliste

- 1: Elektronisches Bauelement
- 11: Kontaktierungsschicht, Grenzfläche
- 2: Trägersubstrat
- 21: Kontaktierungsschicht
- 3: Sinterschicht
- 4: Anordnung mit Bauelement und Substrat
- 5: Hülle, Membran
- 6: Presse
- 61: Druckkammer
- 7: Fluid (Gas, Flüssigkeit)

## Patentansprüche

1. Verfahren zum Befestigen von elektronischen Bauelementen auf Substraten durch Drucksintern, bei welchem Verfahren
- eine im Wesentliche aus einem Metallpulver bestehende Sinterschicht (3) auf einer mit einer Kontaktierungsschicht versehenen Grenzfläche (11) eines Bauelements (1) und/ oder auf einer Kontaktschicht (21) eines Substrats (2) aufgetragen wird,
- das Bauelement (1) mit der Grenzfläche auf die Kontaktoberfläche des Substrats (2) aufgesetzt wird, und
- die Anordnung (4) mit Substrat und Bauelement bei Sintertemperatur zusammengepresst wird,
**dadurch gekennzeichnet, dass**
- die Anordnung (4) zum Zusammenpressen in eine Druckkammer (61) einer isostatischen Presse (6) eingebracht wird, und dass
- die Anordnung (4) in der Druckkammer (61) durch ein unter erhöhtem Druck stehendes Fluid (7) zusammengepresst wird.

2. Verfahren nach Anspruch 1, **dadurch gekennzeichnet, dass**
- die Anordnung (4) vor dem Zusammenpressen in eine elastisch verformbare, gasdichte Hülle (5) eingebracht wird, und dass
- die Hülle (5) anschliessend verschlossen wird.

3. Verfahren nach Anspruch 2, **dadurch gekennzeichnet, dass**
- die Hülle (5) mit der Anordnung (4) vor dem Zusammenpressen zumindest teilweise evakuiert wird.

4. Verfahren nach einem der Ansprüche 1 bis 3, **dadurch gekennzeichnet, dass**
- mehrere Anordnungen (4) mit Substrat und Bauelement in einer Druckkammer (61) zusammengepresst werden.
